# EUROPEAN PATENT APPLICATION

(11) **EP 4 317 544 A1**
(43) Date of publication of application: **07.02.2024**
(21) Application number: 22780934.0
(22) Date of filing: 29.03.2022
(51) Int. Cl.: C30B 29/04, B23B 27/14, B23B 27/20, C01B 32/25, C30B 19/02

(54) **SINGLE-CRYSTAL DIAMOND AND DIAMOND COMPOSITE COMPRISING SAME**

(30) Priority: 31.03.2021 JP 2021061210
(71) Applicant: SUMITOMO ELECTRIC INDUSTRIES, LTD., Osaka-shi, Osaka 541-0041 (JP)
(72) Inventor: NISHIBAYASHI, Yoshiki, Osaka-shi, Osaka 541-0041 (JP); ZUO, Yikang, Osaka-shi, Osaka 541-0041 (JP); LEE, Jin Hwa, Osaka-shi, Osaka 541-0041 (JP); TERAMOTO, Minori, Osaka-shi, Osaka 541-0041 (JP); KOBAYASHI, Yutaka, Osaka-shi, Osaka 541-0041 (JP); SUMIYA, Hitoshi, Osaka-shi, Osaka 541-0041 (JP)
(74) Representative: Boult Wade Tennant LLP
(86) International application number: PCT/JP2022/015486
(87) International publication number: WO 2022/210723

(57) **Abstract**

A single-crystal diamond including: a growth striation parallel to a main growth surface; and a low-index crystal plane, wherein the growth striation in at least part of the single-crystal diamond has an off-cut angle with respect to the low-index crystal plane.

## Description

### Technical Field

The present disclosure relates to a single-crystal diamond and a diamond composite containing the single-crystal diamond. The present application claims priority to Japanese Patent Application No. 2021-061210, filed March 31, 2021. The entire contents of this Japanese patent application are incorporated herein by reference.

### Background Art

Diamonds have been used in various applications, such as heat sinks, wire-drawing dies, precision machining tools, optical components, laser windows, crystals for spectroscopy, monochromators, anvils for ultra-high pressure generators, and semiconductor diamond substrates. Among these applications, in particular, in the fields of optical components, laser windows, crystals for spectroscopy, monochromators, anvils for ultra-high pressure generators, and semiconductor diamond substrates, diamonds with fewer crystal defects and less distortion have been developed to improve performance (for example, Japanese Unexamined Patent Application Publication No. 7-116494 (Patent Literature 1), Japanese Unexamined Patent Application Publication No. 7-148426 (Patent Literature 2), Japanese Unexamined Patent Application Publication No. 9-165295 (Patent Literature 3)).

### Citation List

### Patent Literature

PTL 1: Japanese Unexamined Patent Application Publication No. 7-116494
PTL 2: Japanese Unexamined Patent Application Publication No. 7-148426
PTL 3: Japanese Unexamined Patent Application Publication No. 9-165295

### Summary of Invention

A single-crystal diamond according to the present disclosure is
a single-crystal diamond including: a growth striation parallel to a main growth surface; and a low-index crystal plane,
wherein the growth striation in at least part of the single-crystal diamond has an off-cut angle with respect to the low-index crystal plane.

A diamond composite according to the present disclosure is
a diamond composite including:
the single-crystal diamond; and
a seed substrate,
wherein the seed substrate has a main surface and a low-index crystal plane, and
the main surface has an off-cut angle with respect to the low-index crystal plane of the seed substrate.

### Brief Description of Drawings

[Fig. 1] Figure 1 is a schematic cross-sectional view of a diamond composite containing a single-crystal diamond according to the present disclosure and a seed substrate.
[Fig. 2] Figure 2 is a schematic cross-sectional view of an example of a sample chamber structure used in the manufacture of a synthetic single-crystal diamond according to an aspect of the present disclosure.

### Description of Embodiments

### [Problems to be Solved by Present Disclosure]

In recent years, crystals for next-generation spectroscopy in the synchrotron radiation region, ultraprecision cutting tools, high-frequency device application substrates, and magnetic sensor application substrates have attracted attention as new applications of diamonds. In these applications, it is desired to improve crystallinity over a wide range by the addition of a trace amount of impurities. In particular, a single-crystal diamond manufactured by a high-temperature high-pressure method is stably synthesized in a thermal equilibrium state and can have higher crystallinity than single-crystal diamonds manufactured in a non-equilibrium state by a gas-phase synthesis method. In particular, in magnetic sensor applications, to improve performance, it is desired to further improve magnetic sensitivity and fluorescence intensity associated with the improvement in crystallinity.

The present disclosure has been made in view of the above circumstances and aims to provide a single-crystal diamond with high magnetic sensitivity and fluorescence intensity and a diamond composite containing the single-crystal diamond.

### [Advantageous Effects of Present Disclosure]

The present disclosure can provide a single-crystal diamond with high magnetic sensitivity and fluorescence intensity and a diamond composite containing the single-crystal diamond.

### [Description of Embodiments of Present Disclosure]

First, embodiments of the present disclosure are described below.
[1] A single-crystal diamond according to an aspect of the present disclosure is
   a single-crystal diamond including: a growth striation parallel to a main growth surface; and a low-index crystal plane,
   wherein the growth striation in at least part of the single-crystal diamond has an off-cut angle with respect to the low-index crystal plane.

   A single-crystal diamond with such a structure has fewer defects and consequently high magnetic sensitivity. Furthermore, the single-crystal diamond has high fluorescence intensity in addition to high magnetic sensitivity because the orientation of nitrogen-vacancy (hereinafter sometimes referred to as "NV") is easily aligned. Thus, a single-crystal diamond with high magnetic sensitivity and fluorescence intensity can be provided.
[2] Another single-crystal diamond according to an aspect of the present disclosure is
   a single-crystal diamond including: a linear defect extending toward a main growth surface; and a crystal axis of a low-index crystal plane,
   wherein the crystal axis in at least part of the single-crystal diamond has an off-cut angle with respect to an average direction of the linear defect extending toward the main growth surface.

   A single-crystal diamond with such a structure has fewer defects and consequently high magnetic sensitivity. Furthermore, the single-crystal diamond has high fluorescence intensity in addition to high magnetic sensitivity because the orientation of nitrogen-vacancy is easily aligned. Thus, a single-crystal diamond with high magnetic sensitivity and fluorescence intensity can be provided.
[3] Preferably, the off-cut angle ranges from 0.1 degrees to 20 degrees. With such a definition, the single-crystal diamond has further improved magnetic sensitivity and fluorescence intensity.
[4] Preferably, the off-cut angle ranges from 0.8 degrees to 15 degrees. With such a definition, the single-crystal diamond has further improved magnetic sensitivity and fluorescence intensity.
[5] Preferably, the low-index crystal plane is an (hkl) plane, and the sum of h, k, and 1 is 5 or less. With such a definition, the single-crystal diamond has further improved magnetic sensitivity and fluorescence intensity.
[6] Preferably, the (hkl) plane is a (100) plane or a (111) plane. With such a definition, the single-crystal diamond also has a high fluorescence intensity contrast ratio. In particular, the (100) plane is preferably in a <100> off direction.
[7] Preferably, the (hkl) plane is a (111) plane, and a side is <110>. With such a definition, the single-crystal diamond also has a higher fluorescence intensity contrast ratio. The term "side", as used herein, refers to a peripheral line segment constituting the (111) plane of the main surface and is composed of a line segment perpendicular to a vector <111> perpendicular to the (111) plane.
[8] Preferably, a region with the off-cut angle in the single-crystal diamond has a volume percentage of 0.8% by volume or more. With such a definition, the single-crystal diamond has high magnetic sensitivity, fluorescence intensity, and total integrated fluorescence intensity.
[9] Preferably, a sum of a growth surface forming an off-cut angle between the growth striation and the low-index crystal plane and a just-growth surface on which the off-cut angle is eliminated is a maximum compared with an area of a plane with another plane orientation. With such a definition, the single-crystal diamond has higher magnetic sensitivity, higher fluorescence intensity, and a higher fluorescence intensity contrast ratio.
[10] Preferably, a sum of a growth surface forming an off-cut angle between a linear defect and a crystal axis of the low-index crystal plane and a just-growth surface on which the off-cut angle is eliminated is a maximum compared with an area of a plane with another plane orientation. With such a definition, the single-crystal diamond has higher fluorescence intensity and a higher fluorescence intensity contrast ratio.
[11] Preferably, the growth surface is 1.5 times or more larger than other surfaces of the single-crystal diamond. With such a definition, the single-crystal diamond is more suitable to form a device.
[12] Preferably, the single-crystal diamond has a size of 5 mm or more. With such a definition, the single-crystal diamond has higher fluorescence intensity and is more suitable to form a device. In the present disclosure, a crystal with fewer defects can be formed over the entire surface of the substrate, and the defects can be fewer in the in-plane direction than in the thickness direction. Thus, the single-crystal diamond has fewer defects and a large size. A single-crystal diamond with a large size can easily have high fluorescence intensity as a whole and is suitable as a crystal for a sensor.
[13] Preferably, the single-crystal diamond has at least one growth sector, wherein the growth sector has a single proportion of 50% or more based on the area of the main growth surface. With such a definition, the single-crystal diamond has higher magnetic sensitivity, higher fluorescence intensity, and a higher fluorescence intensity contrast ratio, and is more suitable to form a device. A single proportion of a sector means ensured uniformity of fluorescence intensity for a sensor. The ensured uniformity means that fluorescence intensity with optimal magnetic field sensitivity can be maximized. The term "growth sector", as used herein, refers to a region grown in the same plane orientation. A growth sector in one continuous region may also be referred to as a "single growth sector".
[14] Preferably, the single-crystal diamond has two or more growth sectors, wherein at least one growth sector boundary is a boundary between a growth sector on a low-index crystal plane and a growth sector on an off-cut angle plane. With such a definition, the single-crystal diamond has higher magnetic sensitivity, higher fluorescence intensity, and a higher fluorescence intensity contrast ratio, and is more suitable to form a device. This is because a portion with this growth sector boundary has fewer defects and high magnetic field sensitivity.
[15] A diamond composite according to an aspect of the present disclosure is a diamond composite including
   the single-crystal diamond; and
   a seed substrate,
   wherein the seed substrate has a main surface and a low-index crystal plane, and
   the main surface has an off-cut angle with respect to the low-index crystal plane of the seed substrate.

   The single-crystal diamond constituting the diamond composite has high magnetic sensitivity and fluorescence intensity. Thus, a diamond composite with high magnetic sensitivity and fluorescence intensity can be provided.
[16] Preferably, the seed substrate has a size of 2 mm or more. With such a definition, the diamond composite has high magnetic sensitivity, high fluorescence intensity, and a high fluorescence intensity contrast ratio, and forms a device with substantially high fluorescence intensity. This is because a seed substrate with a small size has a small region of off-cut angle growth in the whole large grown crystal, thus reducing the advantages of the present disclosure.

In a single-crystal diamond composite according to the present disclosure, a single-crystal diamond grown on a low-index crystal plane other than the low-index crystal plane of the main surface also has crystallinity similar to a single-crystal diamond grown on the low-index crystal plane of the main surface. As evidence thereof, the single-crystal diamond composite is a single-crystal diamond with a plurality of growth sectors with growth sector boundaries derived from different growth surface orientations, one of which has the main surface with an off-cut angle with respect to the low-index crystal plane. This shows that this is not a single crystal manufactured by gas-phase synthesis. This is because, in a single-crystal diamond manufactured by gas-phase synthesis, a diamond with high crystallinity is not grown in different plane orientations, and a substrate with a plurality of growth sectors cannot be manufactured. The presence of a plurality of growth sectors can be confirmed by observing a patch-like distribution of light-emitting centers.

### [Details of Embodiments of Present Disclosure]

An embodiment of the present disclosure (hereinafter referred to as "the present embodiment") is described below. The present embodiment is not limited to this. In the present disclosure, like reference numerals denote like parts or equivalents thereof throughout the figures. For the sake of clarity and simplification of the drawings, the dimensions, such as length, width, thickness, and depth, are appropriately modified and do not necessarily represent actual dimensions. In the present description, individual directions are indicated by [ ], and generic directions including crystal-geometrically equivalent directions are indicated by < >. Individual plane orientations are indicated by ( ), and generic plane orientations including crystal-geometrically equivalent plane orientations are indicated by { }. The notation "X to Y", as used herein, refers to the upper and lower limits of the range (that is, equal to or more than X and equal to or less than Y). When the unit is not described in X but is described in Y, the unit of X and the unit of Y are the same.

### «Single-Crystal Diamond»

The single-crystal diamond according to the present embodiment is preferably
a single-crystal diamond including: a growth striation parallel to a main growth surface; and a low-index crystal plane,
wherein the growth striation in at least part of the single-crystal diamond has an off-cut angle with respect to the low-index crystal plane. In one aspect of the present embodiment, the single-crystal diamond is preferably a single-crystal diamond formed by a high-temperature high-pressure method.

A single-crystal diamond with such a structure has fewer defects due to stacking errors. Alternatively, the single-crystal diamond means a single-crystal diamond including an off-cut angle growth region 31 in which a stacking error, if occurring, can be corrected to reduce defects. In the off-cut angle growth region, a growth striation is a plane on which crystals are stacked at almost the same time like a stratum, and the low-index crystal plane is a plane on which crystals are stacked in order. Thus, if these planes completely coincide with each other, a stacking error occurs at a certain probability, or information of the order to be stacked is lost due to a stacking error. Consequently, a stacking error continues to a growth surface or spreads on a substrate surface. On the other hand, when these planes have an off-cut angle, the order of crystal planes remains in a kink of a crystal extending by step growth in the transverse direction, and a mechanism is provided for immediately recovering and correcting crystalline order even if a stacking error occurs. This extremely reduces the number of stacking faults during crystal growth.

Furthermore, the off-cut angle growth does not have the function of repairing a linear defect, such as a dislocation, derived from a seed substrate, but has the effect of slightly shifting or bonding a linear defect. This can also reduce the density of linear defects and the number of defects and also has the effect of shifting a linear defect from the center, which is essential for use in a device, to an edge.

Furthermore, a kink portion in an off-substrate has a certain direction in crystal binding and has the effect of maintaining the certain direction even for slightly biased bonding to carbon when nitrogen is incorporated or the like or for the incorporation of nitrogen together with a defect. Such a bias forms a certain bias in the bonding of N and V when a NV center is formed, and N-V defects (defects of nitrogen and vacancy) are more likely to be aligned in the same direction than randomly bonded N and V Thus, the NV light emission characteristics do not vary, and there is an effect of increasing fluorescence intensity under specific measurement conditions. This effect characteristically has an influence on magnetic sensitivity or fluorescence intensity.

Although an off-cut angle grown single-crystal diamond is a crystal that exactly has the above effect, a just-surface growth region 32 in which the off-cut angle on the off-cut angle grown single-crystal diamond is almost eliminated also retains the effect until the off-cut angle region disappears and for a while thereafter. This is because the seed substrate has fewer crystal defects for a while. Thus, partial inclusion of a single-crystal diamond with a growth striation parallel to the main growth surface and with a low-index crystal plane has this effect.

The term "main growth surface" refers to the growth surface with the largest area among the growth surfaces of the single-crystal diamond. The term "growth surface" refers to a surface of a single-crystal diamond manufactured by crystal growth by a temperature difference method using a seed substrate described later. It is thought that a single-crystal diamond typically has a plurality of growth surfaces. The term "growth striation" refers to a surface on which a fluctuation in impurity concentration or the like occurs due to a fluctuation in crystal growth conditions, and a subtle difference in characteristics can be observed as a striation in photoluminescence (PL), cathodoluminescence (CL), and the like. The present disclosure is directed to a diamond manufactured by a high-temperature high-pressure method, and the presence or absence of a growth striation and the off-cut angle can be examined in an image recognized by the intensity of light emission. The light emission may originate from those related to a H3 center with a peak at 503 nm, those related to a N3 center with a peak at 415 nm, or those related to a band A, which is considered to be derived from a D-A pair with a peak in the range of 420 to 450 nm. In addition to the above, light emission may originate from those related to a NV⁰ center with a peak at 575 nm or those related to a NV⁻ center with a peak at 638 nm, which are observed by introducing a defect by electron-beam irradiation or the like followed by heat treatment. The term "low-index crystal plane" refers to a crystal plane with a low index of 5 or less.

In one aspect of the present embodiment, the single-crystal diamond is
a single-crystal diamond including: a main growth surface; and a crystal axis of a low-index crystal plane,
wherein the crystal axis in at least part of the single-crystal diamond has an off-cut angle with respect to an average direction of a linear defect extending toward the main growth surface.

In another aspect of the present embodiment, the single-crystal diamond is
a single-crystal diamond including: a linear defect extending toward a main growth surface; and a crystal axis of a low-index crystal plane,
wherein the crystal axis in at least part of the single-crystal diamond has an off-cut angle with respect to an average direction of the linear defect extending toward the main growth surface.

A single-crystal diamond with such a structure has fewer defects due to stacking errors. Alternatively, the single-crystal diamond means an off-cut angle grown single-crystal diamond in which a stacking error, if occurring, can be corrected to reduce defects. More specifically, this means that the average direction of a linear defect is almost the crystal stacking direction, and the crystal axis of the low-index crystal plane is the crystal plane stacking direction. Thus, if these planes completely coincide with each other, a stacking error occurs at a certain probability, or information of the order to be stacked is lost due to a stacking error. Consequently, a stacking error continues to a growth surface or spreads on a substrate surface. On the other hand, when the direction and the axis have an off-cut angle, the order of crystal planes remains in a kink of a crystal extending by step growth in the transverse direction, and a mechanism is provided for immediately recovering and correcting crystalline order even if a stacking error occurs. This extremely reduces the number of stacking faults during crystal growth.

Furthermore, the reduction of a linear defect, such as a dislocation, derived from a seed substrate, the effects of the NV light emission characteristics, or the effects remaining for a while even after the off-cut angle growth is eliminated are as described above.

The term "crystal axis" refers to an axis uniquely representing a low-index crystal plane and an axis of a vector perpendicular to this plane. The phrase "an average direction of a linear defect extending toward a main growth surface" refers to an average direction of a plurality of vectors obtained by linear approximation by the least squares method of individual linear defects extending toward the main growth surface analyzed by X-ray topography or the like. Extending toward a main growth surface can be judged by whether it crosses the main growth surface or not in linear approximation.

In the present embodiment, the single-crystal diamond may be in the form of a grown grain or in the form of a grown substrate. The term "grown grain", as used herein, refers to a single-crystal diamond itself grown by a manufacturing method described later. The term "grown substrate" refers to a substrate manufactured by forming the grown grain into an approximately plate-like shape.

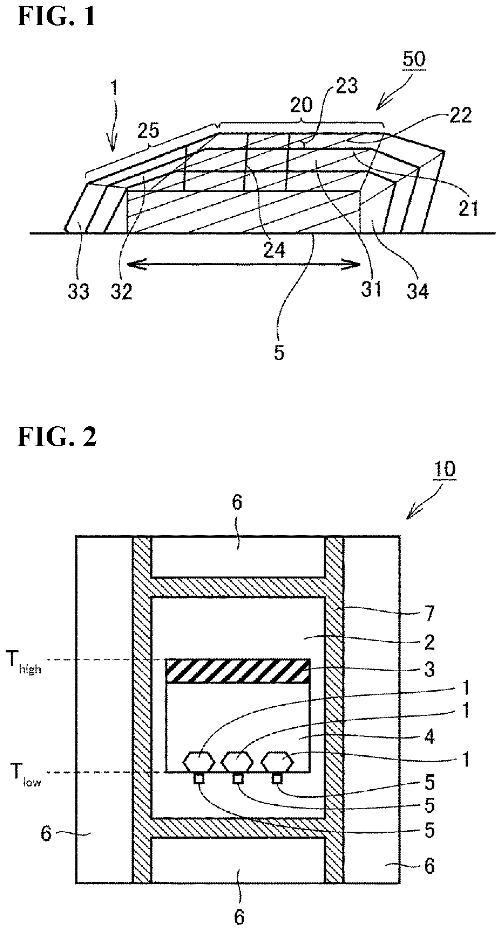

The main growth surface 20 is a growth surface parallel to a growth striation 21, and the area of the main growth surface is preferably larger than the areas of the other growth surfaces (for example, Fig. 1).

In the present embodiment, the low-index crystal plane is an (hkl) plane, and the sum of h, k, and 1 is preferably 5 or less, more preferably 3 or less. The lower limit of the sum of h, k, and 1 may be 1 or more or 2 or more. This is because, in the low-index plane of this definition, the distance between adjacent atoms on the outermost surface is not elongated and short, so that a stable terrace growth surface is formed. In other words, this is because a kink of stable crystal growth can be formed, off-cut angle growth in the present disclosure can be significantly realized, and the characteristics related to NV are also good.

The (hkl) plane is, for example, a (111) plane, a (100) plane, a (110) plane, or a (311) plane. In the present embodiment, the (hkl) plane is preferably a (111) plane or a (100) plane. Alternatively, preferably, the (hkl) plane is a (100) plane and is a <100> off tilt.

In the (111) plane and the (100) plane, the terrace growth surface is most stable, and the off-cut angle growth is most significant. The (100) plane is a stable growth surface and is a single crystal that can have the advantages of off-cut angle growth in the present disclosure. Furthermore, selecting an off-cut angle in the <100> direction can also align NV bond directions, thereby improving the fluorescence intensity related to NV The (111) plane is a plane expected to most align the NV bond directions, but is a difficult plane due to a largest number of stacking faults. However, a single crystal manufactured by the off-cut angle growth in the present disclosure can solve this problem.

In one aspect of the present embodiment, preferably, the (hkl) plane is a (111) plane, and the side is <110>.

The present disclosure is effective when the main surface is grown larger than the other surfaces because the off-cut angle growth can be step growth in secondary growth. Under such conditions, the (111) plane substrate can be increased in size when the side of the seed substrate is a triangle or a hexagon of <110>, and when the side of the substrate after growth is also a triangle or a hexagon of <110> and has a significant shape capable of forming a single crystal according to the present disclosure, the ratio of the off-cut angle growth region can be increased, and a single-crystal diamond with good NV-related characteristics can be manufactured.

### <Off-Cut Angle>

In one aspect of the present embodiment, the growth striation 21 has an off-cut angle 23 with respect to the low-index crystal plane 22 in at least part of the single-crystal diamond 1 (for example, Fig. 1).

In another aspect of the present embodiment, the crystal axis has an off-cut angle with respect to an average direction 24 of a linear defect extending toward the main growth surface in at least part of the single-crystal diamond 1. The average direction of the linear defect extending toward the main growth surface is determined by the following method. First, a linear defect analyzed by X-ray topography is linearly approximated by the least squares method as the average direction of the linear defect. A linear defect with an approximate straight line crossing the main growth surface is a linear defect extending toward the main growth surface. The average direction of a linear defect is calculated by selecting an approximate straight line of the linear defect and averaging the vector.

In general, "the off-cut angle of the growth striation with respect to the low-index crystal plane" is the same as "the off-cut angle of the crystal axis with respect to the average direction of dislocation toward the main growth surface".

The off-cut angle preferably ranges from 0.1 degrees to 20 degrees, more preferably 0.8 degrees to 15 degrees, still more preferably 2 degrees to 8 degrees. An off-cut angle of less than 0.1 degrees results in an increase in a region without off-cut angle growth, resulting in no difference from known growth and a reduction in the advantages of high magnetic sensitivity and fluorescence intensity in the present disclosure. An off-cut angle of more than 20 degrees results in a smaller width of a terrace for step growth, an increased number of defects, and a reduction in the advantages of the present disclosure. An off-cut angle in the range of 0.8 degrees to 15 degrees results in a step growth terrace with a width suitable for the growth conditions for achieving the growth rate of the present disclosure and results in more preferred characteristics. An off-cut angle in the range of 2 degrees to 8 degrees results in a further appropriate balance between the terrace width and the growth rate and results in still more preferred characteristics. The optimal range for the off-cut angle results from the importance of the balance between the width of a terrace on a low-index plane formed by the off-cut angle and the growth rate.

The off-cut angle is determined as described below. First, the average direction of a linear defect with respect to a temporary plane of a measurement sample is calculated by X-ray topography analysis. On the other hand, the axial direction of a low-index crystal plane with respect to the temporary plane of the measurement sample is measured by an X-ray diffraction method. The off-cut angle of the average direction of the linear defect with respect to the axial direction of the low-index crystal plane can be calculated from these measurement results.

### <Growth Sector>

In the present embodiment, the single-crystal diamond has at least one growth sector,
wherein the growth sector preferably has a single proportion of 50% or more, more preferably 70% or more, still more preferably 80% or more, based on the area of the main growth surface. For example, in Fig. 1, the single-crystal diamond 1 is composed of a first growth sector 31, a second growth sector 32, a third growth sector 33, and a fourth growth sector 34. The growth striation 21 in the first growth sector 31 has the off-cut angle 23 with respect to the low-index crystal plane 22, and the first growth sector 31 may be referred to as an "off-growth region". The second growth sector 32 may be referred to as a "just-surface growth region" because the growth striation in the second growth sector is parallel to the low-index crystal plane 22 (that is, the off-cut angle is 0 degrees).

The single proportion of the growth sector may have any upper limit. The growth sector may have a single proportion of 99% or less or 95% or less based on the area of the main growth surface. The single growth sector may be the first growth sector 31 or the second growth sector 32. Both of them belong to the main growth surface. However, it is difficult for the third growth sector 33 and the fourth growth sector 34 to become a single growth sector. This is because these are not the main surface of growth.

The single proportion of the growth sector is calculated as described below. Growth sectors have different impurity concentrations and therefore have different fluorescence intensities. Thus, the distribution of fluorescence on a substrate surface is determined by PL or CL, and the boundary of each growth sector is observed as a clear line. An area ratio along the boundary can be determined to determine the single proportion of the largest sector. Furthermore, a confocal microscope can be used to determine a three-dimensional sector region distribution, or the ratio of an area exposed on the surface can also be used to calculate a single proportion.

### <Shape of Single-Crystal Diamond>

In one aspect of the present embodiment, the main growth surface preferably has an inscribed circle diameter of 8 mm or more. The inscribed circle diameter may have any upper limit, but a size of more than 50 mm is difficult with the present technology.

In another aspect of the present embodiment, the single-crystal diamond preferably has a size of 5 mm or more, more preferably 7 mm or more, still more preferably 9 mm or more. The upper limit of the size of the single-crystal diamond may be 50 mm or less or 40 mm or less. The size of the single-crystal diamond can be determined by a method using an optical microscope with a length measurement function.

In one aspect of the present embodiment, the volume percentage of a region with the off-cut angle (for example, the first growth sector in Fig. 1) in the single-crystal diamond is preferably 0.8% by volume or more, more preferably 5% by volume or more, still more preferably 10% by volume or more. The upper limit of the volume percentage may be, but is not limited to, 100% by volume or less or 95% by volume or less. This is because an ideal 100% by volume can be achieved by using as large a seed substrate as possible to prepare a large crystal and cutting out a single sector. The volume percentage can be determined by the following method.

Growth sectors have different impurity concentrations and therefore have different fluorescence intensities. Thus, the volume distribution of fluorescence on a substrate surface, a back surface, and two or three cross sections can be determined by PL or CL. The boundary of each growth sector is observed as a clear plane, and a volume ratio can be determined using the boundary surface as a boundary to determine the volume percentage of a region with an off-cut angle. Furthermore, a confocal microscope can also be used to determine a three-dimensional sector region distribution, and the volume percentage can also be calculated from the volume ratio of each sector.

As described above, in a region grown at an off-cut angle, the order of crystallinity can be maintained, and a crystal with fewer defects can be formed. Furthermore, a crystal grown on the crystal can also retain the order of crystallinity for a while and can have fewer defects. Thus, even in a terrace portion of a just-surface, which is not off-cut angle growth, while an off-cut angle growth region remains on part of the surface and for a while after the off-cut angle is completely eliminated, a step is supplied to the terrace of the just-surface from a side surface with a high growth rate. Thus, when a step is supplied from a specific one, as in the principle of off-cut angle growth, the order of crystallinity is maintained, and a crystal with fewer defects is formed. Thus, not only the off-cut angle growth region but also a crystal grown on the region as a base substrate has fewer defects.

In one aspect of the present embodiment, the sum of the growth surface 20 forming the off-cut angle between the growth striation and the low-index crystal plane and a just-growth surface 25 on which the off-cut angle is eliminated is preferably a maximum compared with an area of a plane with another plane orientation. In another aspect of the present embodiment, the sum of the growth surface 20 forming the off-cut angle between a linear defect and a crystal axis of the low-index crystal plane and the just-growth surface 25 in which the off-cut angle is eliminated is preferably a maximum compared with an area of a plane with another plane orientation. The growth surface is preferably 1.5 times or more, more preferably twice or more, larger than the other surfaces of the single-crystal diamond.

The crystal growth conditions under which the low-index crystal plane becomes the largest plane are that the largest crystal plane is the slowest growth surface. Thus, a crystal is easily grown in the transverse direction and thereby increases the area. Furthermore, the growth conditions are also characterized in that two-dimensional nuclear growth on the low-index crystal plane is suppressed and kink growth tends to be preferential. The suppression of the two-dimensional nuclear growth prevents the misarrangement of crystals and reduces defects in the crystals.

### <Linear Defect>

In the present embodiment, the density of linear defects passing through the main growth surface is preferably less than 10⁴ /cm², more preferably less than 1000 /cm². The lower limit of the density of linear defects may be 0 /cm² or more or 10 /cm² or more. The density of linear defects is measured in an etching test. More specifically, it is measured by the following procedure. The phrase "passing through the main growth surface" means that an etch pit can be observed on the surface.

A single-crystal diamond is immersed in a potassium nitrate (KNO₃) solution as an etchant and is heated in a platinum crucible at 600°C to 700°C for 0.5 to 2 hours. After slow cooling, the single-crystal diamond is taken out, and the main growth surface is observed with an optical microscope. An inverted pyramidal etch pit is observed, and the size of the etch pit is adjusted by the crucible temperature and the treatment time depending on the etch-pit density. For this adjustment, first, the conditions are determined after the density is roughly determined by treatment under conditions where a small etch pit can be formed. The size is determined for each etch-pit density such that etch pits do not overlap. The number of etch pits does not change while the etch pits are enlarged, and the size of etch pits is adjusted to the size of the field of view to be evaluated (the density of etch pits). As an example of the adjustment, at an etch-pit density as high as 5000 /cm² or more, the size of etch pits ranges from approximately 5 to 20 µm square such that etch pits do not overlap. Three portions with a high density are selected in a growth surface, and the number of etch pits is counted up to an area containing approximately 100 etch pits in a rectangular measurement region of 1 mm or less. The average is calculated from the area and the number of etch pits. At an etch-pit density of less than 5000 /cm², the etch pits are gradually increased in size to be observed with a microscope even at low magnification. In a sample in which a portion with a high density cannot be determined, etch pits are counted over the entire sample growth surface and are calculated from the total surface area. On the basis of the above procedure, the number of etch pits per cm² is calculated. The term "etch pit", as used herein, refers to a clear inverted pyramidal pit. Etch pits of approximately the same size are distributed and can be identified as etch pits. In a sample of 5000 /cm² or more, etch pits with a size of up to 1/4 of the size of the majority of etch pits (for example, when a frequency distribution is created, the etch pits with the highest frequency among the etch pits with a size of at least half the maximum etch-pit size) are counted. In a sample of less than 5000 /cm², etch pits with a size of up to 1/8 of the size of the majority of etch pits (for example, when a frequency distribution is created, the etch pits with the highest frequency among the etch pits with a size of at least half the maximum etch-pit size) are counted.

In the present description, the number of etch pits per cm² corresponds to the density of the linear defects. In a single-crystal diamond, the average number of etch pits in the measurement method is referred to as "the density of linear defects passing through the main growth surface" in the present embodiment.

It has been confirmed that, in a single-crystal diamond, even changing a numerical value in the measurement conditions by 20% does not alter the density of the linear defects within one significant figure.

### <Half-Width of ODMR>

An optically detected magnetic resonance (ODMR) spectrum is measured by sweeping a microwave frequency in a constant magnetic field to measure a change in the fluorescence intensity of a NV⁻ center. In a graph with the horizontal axis being the microwave frequency and the vertical axis being the fluorescence intensity, a downward peak is observed in which the fluorescence intensity decreases at a specific microwave frequency. This peak position varies with the magnetic field applied to the diamond. The full-width at half maximum of this peak is measured as the half-width of the ODMR. The fluorescence can typically be observed by irradiation with a 530-nm laser beam and by detecting light near the fluorescence of a zero-phonon line of 638 nm (600 to 700 nm). The excitation light may be in the range of 500 nm to 600 nm. The magnetic field is preferably measured at one NV⁻ center where a peak is slightly split due to the Zeeman effect rather than the zero magnetic field. The NV⁻ center has no problem because relative comparison of each sample is possible by the same evaluation method regardless of whether it is a plurality of ensembles or a single center. A single crystal with a smaller half-width can be judged to contain a smaller amount of surrounding impurities, inclusion, or crystal distortion and have high crystallinity, and has high performance as a magnetic sensor.

### <Applications of Single-Crystal Diamond>

The single-crystal diamond according to the present embodiment can be used in known applications, such as heat sinks, wire-drawing dies, precision machining tools, optical components, laser windows, crystals for spectroscopy, monochromators, anvils for ultra-high pressure generators, and semiconductor diamond substrates. The single-crystal diamond according to the present embodiment has high crystallinity over a wide range including impurities and accordingly has high magnetic sensitivity and fluorescence intensity, and can be suitable for use in new applications, such as crystals for next-generation spectroscopy in the synchrotron radiation region, ultraprecision cutting tools, high-frequency device application substrates, and substrates for magnetic sensor synthesis.

### <<Diamond Composite>>

A diamond composite 50 according to the present embodiment includes:
the single-crystal diamond 1; and
a seed substrate 5,
wherein the seed substrate 5 has a main surface and a low-index crystal plane, and
the main surface has an off-cut angle with respect to the low-index crystal plane of the seed substrate 5 (for example, Fig. 1).

The term "seed substrate", as used herein, refers to a diamond single crystal that serves as a starting point of crystal growth when a single-crystal diamond is manufactured by a temperature difference method described later. The seed substrate may be understood as a seed crystal. The seed substrate may be formed in an approximately rectangular parallelepiped shape.

The off-cut angle of the main surface with respect to the low-index crystal plane of the seed substrate 5 preferably ranges from 0.1 degrees to 20 degrees, more preferably 0.8 degrees to 15 degrees, still more preferably 2 degrees to 8 degrees.

The seed substrate preferably has a size of 2 mm or more, more preferably 3 mm or more, still more preferably 5 mm or more. The upper limit of the size of the seed substrate may be, but is not limited to, 20 mm or less or 10 mm or less. The phrase "the size of the seed substrate", as used herein, refers to the size of the diameter inscribed in the shape of the main surface of the seed substrate. The size of the seed substrate can be determined by the following method. That is, the method includes observing the seed substrate from above with an optical microscope with a length measurement function, drawing an inscribed circle or the like, and measuring the diameter of the inscribed circle.

The area of the main surface of the seed substrate is preferably 1/64 or more, more preferably 1/25 or more, still more preferably 1/8 or more, of the area of the main growth surface of the single-crystal diamond. The area of the main surface of the seed substrate may be 4/5 or less or 3/4 or less of the area of the main growth surface of the single-crystal diamond.

The plane orientation of the main surface of the seed substrate is preferably a (111) plane or a (100) plane.

The diamond composite may be manufactured by a manufacturing method described below and then may be distributed in this state in the market. After the distribution, depending on the use of the single-crystal diamond, the diamond composite may be separated into a seed substrate and the single-crystal diamond, and the single-crystal diamond may be shaped.

### <<Method of Manufacturing Single-Crystal Diamond>>

A method of manufacturing the single-crystal diamond according to the present embodiment includes:
preparing a seed substrate; and
using the seed substrate to grow a single-crystal diamond by a temperature difference method of a high-temperature high-pressure method,
wherein the seed substrate has a main surface and a low-index crystal plane, and
the main surface has an off-cut angle with respect to the low-index crystal plane of the seed substrate. Each step is more specifically described below.

### <Preparing Seed Substrate>

A diamond single crystal is typically used as the seed substrate. The diamond single crystal may be a single crystal manufactured by a high-temperature high-pressure method, or a single crystal manufactured by a temperature difference method in the high-temperature high-pressure method.

A seed substrate can be manufactured by cutting the diamond single crystal by a laser to form a main surface with an off-cut angle with respect to a low-index crystal plane. The off-cut angle of the main surface with respect to the low-index crystal plane preferably ranges from 0.1 degrees to 20 degrees, more preferably 0.8 degrees to 15 degrees, still more preferably 2 degrees to 8 degrees. An apparatus for the laser cutting is a laser apparatus generally used to cut materials. The laser may be a nanosecond laser, a picosecond laser, a femtosecond laser, or a water column laser. Although the main surface is preferably evenly polished, even if not polished, the main surface with a surface roughness of not more than a certain level causes no problem.

The seed substrate preferably has a size of 2 mm or more, more preferably 3 mm or more, still more preferably 5 mm or more. The upper limit of the size of the seed substrate may be, but is not limited to, 20 mm or less or 10 mm or less.

The seed substrate with an increased size can be used to easily increase the size of the single-crystal diamond and consequently increase the size of a grown substrate. A large grown substrate can result in a large off-growth region. The seed substrate with an increased size can be used to increase the size of a grown substrate and the size of a single growth sector.

The plane orientation of the main surface of the seed substrate is preferably a (111) plane or a (100) plane. The off-direction may be any direction and is preferably the <100> direction in the (100) plane.

### <Growing Single-Crystal Diamond by Temperature Difference Method>

A single-crystal diamond can be manufactured, for example, by a temperature difference method using a sample chamber with the structure illustrated in Fig. 2.

As illustrated in Fig. 2, in a sample chamber 10 used to manufacture a single-crystal diamond, an insulator 2, a carbon source 3, a solvent metal 4, and a seed substrate 5 (seed crystal 5) are disposed in a space surrounded by a graphite heater 7, and a pressure medium 6 is disposed outside the graphite heater 7. The temperature difference method is a high-temperature high-pressure synthesis method of providing a vertical temperature gradient in the sample chamber 10, placing the carbon source 3 in a high-temperature portion (T_{high}), placing the seed substrate 5 of diamond in a low-temperature portion (T_{low}), placing the solvent metal 4 between the carbon source 3 and the seed substrate 5, and growing a single-crystal diamond on the seed substrate 5 at a temperature not lower than the temperature at which the solvent metal 4 melts and at a pressure not lower than the pressure at which the diamond is thermally stable. A synthesis at high temperature and pressure where a diamond layer becomes a stable layer as described above is preferable to a gas-phase synthesis method in a metastable state. This is because crystal growth with fewer defects is possible on a low-index crystal plane of a side surface, which is different from the main surface. In the gas-phase synthesis, the crystal growth conditions of different low-index planes are different, and under the same conditions, therefore, a crystal with fewer defects is not simultaneously grown on the low-index crystal plane of the main surface and on the low-index crystal plane different from the main surface (growth toward the side surface). Crystal distortion and defects on a side surface have a great influence when growth on the main surface is increased to 1.2 times or more in size.

The carbon source 3 is preferably a diamond powder. Graphite or pyrolytic carbon may also be used. The solvent metal 4 may be one or more metals selected from iron (Fe), cobalt (Co), nickel (Ni), manganese (Mn), and the like, or an alloy containing these metals.

The solvent metal 4 may further contain one or more elements selected from the group consisting of titanium (Ti), vanadium (V), chromium (Cr), manganese (Mn), copper (Cu), zirconium (Zr), niobium (Nb), molybdenum (Mo), ruthenium (Ru), rhodium (Rh), hafnium (Hf), tantalum (Ta), tungsten (W), osmium (Os), iridium (Ir), and platinum (Pt)

The conditions of the temperature difference method are, for example, a pressure of 5.6 GPa, a temperature of 1350°C, and 100 to 200 hours. A solvent to be used is, for example, a solvent in which an Fe-Co metal containing 50% by weight of Co is selected and 0.1% to 1.0% by weight of Ti is added to control the amount of nitrogen added.

In addition to the steps described above, the method of manufacturing the single-crystal diamond according to the present embodiment may include irradiating the manufactured single-crystal diamond with either or both of an electron beam and a particle beam at an energy in the range of 50 MGy to 1000 MGy, or annealing the single-crystal diamond irradiated with the electron beam and/or the particle beam at atmospheric pressure in the temperature range of 700°C to 1800°C.

In the above method, a grown grain with an off-growth region is formed in which a growth striation has an off-cut angle with respect to a low-index crystal plane. When the growth striation has an off-cut angle, a kink in a step becomes a preferential growth mode, and stacking errors of crystals, misarrangement of crystals, and the like do not occur during crystal growth. Furthermore, a dislocation easily shifts to the outside of a grown grain and is less likely to remain in the central portion of the grown grain, and stacking faults are extremely reduced. Thus, the method is effective in reducing defects. The method is applied to the temperature difference method of the high-temperature high-pressure method to maintain growth with fewer defects because the base growth surface has fewer defects not only in an off-growth surface but also in just-surface growth without the off-cut angle. In a high-pressure synthesis method, an off-growth method has not been widely used because of the thermal equilibrium of a diamond crystalline layer. Furthermore, the seed substrate is as small as 1/10 of the size of a grown grain, and the plane orientation of the main surface of the seed substrate becomes a just-surface immediately after the start of growth and has almost no influence on a subsequently grown crystal. Only the crystallinity of some local portion of the seed substrate has an influence, and the local portion is unintentionally selected and could not be controlled. In a seed substrate with a size of 2 mm or more, however, when the crystallinity of the entire main surface of the seed substrate is reflected, and if the main surface is off with respect to the crystal plane, a crystal not only grows in the vertical direction but grows in the vertical direction while maintaining the crystallinity in the horizontal direction. Thus, the present inventors have found for the first time a growth method capable of exhibiting this effect of eliminating stacking errors in a high-temperature high-pressure method. A low-index crystal plane is a flat atomic-level terrace plane, and a low-index crystal plane with an off-cut angle is a plane composed of an atomic-level terrace and an atomic-level step. A step provides a stable bonding state in which an atom is more easily incorporated into a crystal than a terrace. Such a site (an atomic-level place) at which an atom can be stabilized is referred to as a kink. In addition to the step, a jagged portion of the step when viewed from above is also a kink, which is a more stable site than the step.

When the main surface of the seed substrate has an off-cut angle with respect to the low-index crystal plane, the effects described above are exhibited, which favorably affects not only an off-grown crystal but also a just-surface grown crystal having an off-grown crystal as a base. Thus, a grown crystal may be included only in a part thereof.

### <<Method of Manufacturing Single-Crystal Diamond with NV' Center>>

When a single-crystal diamond containing substitutional nitrogen in which the nitrogen concentration is controlled using a Ti getter can be manufactured, the substrate can be used to manufacture a NV⁻ center. First, a single-crystal diamond containing substitutional nitrogen is preferably irradiated with an electron beam at an accelerating voltage in the range of 1 to 3 MeV, more preferably 2 to 3 MeV The electron dose preferably ranges from 1 to 50 × 10¹⁷ cm⁻², more preferably 1 to 5 × 10¹⁸ cm⁻². This is preferably followed by annealing in a vacuum at 700°C to 1100°C, more preferably 900°C to 1000°C. The annealing may be performed in an inert gas or in a nitrogen atmosphere instead of in a vacuum. The annealing time preferably ranges from 30 minutes to 3 hours, more preferably 1 to 2 hours. A graphite layer formed on the diamond surface after annealing is preferably removed by hot mixed acid treatment. Treatment in hydrogen plasma or treatment in hydrogen plasma containing a trace amount (1% by mole or less) of oxygen atoms may also be performed. Through the above process, substitutional nitrogen can combine with a vacancy generated by electron-beam irradiation and form a NV center, the NV center can be partly or mostly converted into a NV⁻ center while a small amount of the substitutional nitrogen remains alone, and a single-crystal diamond with a clean surface including the NV⁻ center can be manufactured.

### EXAMPLES

Although the present invention is described in detail in the following examples, the present invention is not limited to these examples.

<<Manufacture of Single-Crystal Diamond>>

A single-crystal diamond was synthesized by the temperature difference method using a sample chamber with the structure illustrated in Fig. 2. An Fe-Co solvent metal containing 50% by weight of Co and 50% by weight of Fe was used as a solvent metal. A diamond powder was used as a carbon source, and a diamond single crystal with the structure shown in Tables 1-1 and 1-2 was used as a seed substrate (seed crystal). The following conditions were used for the temperature difference method. The nitrogen concentration was a general concentration containing 5 to 10 ppm in the substitution type.

### <Conditions of Temperature Difference Method>

Pressure: 5.6 GPa
Temperature of substrate portion: 1350°C
Holding time: 150 hours

**[Table 1-1]**

| Sample | Seed substrate | | | | |
|---|---|---|---|---|---|
| | Size (mm) | Low-index crystal plane (hkl) plane | h+k+I | Off-cut angle* (° ) | Off direction |
| 1 | 8 | (001) | 1 | 0.15 | <100> |
| 2 | 6 | (001) | 1 | 0.82 | <100> |
| 3 | 4 | (001) | 1 | 2.4 | <100> |
| 4 | 3.5 | (001) | 1 | 7.5 | <100> |
| 5 | 3.5 | (001) | 1 | 9 | <100> |
| 6 | 3 | (001) | 1 | 14.5 | <100> |
| 7 | 3 | (001) | 1 | 19.5 | <100> |
| 8 | 7 | (001) | 1 | 7.5 | <100> |
| 9 | 4 | (001) | 1 | 7.5 | <100> |
| 10 | 5 | (001) | 1 | 7.5 | <100> |
| 11 | 5 | (001) | 1 | 9 | <100> |
| 12 | 5 | (001) | 1 | 7.5 | <100> |
| 13 | 5 | (001) | 1 | 2.8 | <100> |
| 14 | 5 | (001) | 1 | 3 | <110> |
| 101 | 0.5 | (001) | 1 | 0 | - |

| | | | | | |
|---|---|---|---|---|---|
| * means the off-cut angle of a main surface with respect to the low-index crystal plane. | | | | | |

**[Table 1-2]**

| Sample | Seed substrate | | | | |
|---|---|---|---|---|---|
| | Size (mm) | Low-index crystal plane (hkl) plane | h+k+I | Off-cut angle*(° ) | Off direction |
| 21 | 5 | (111) | 3 | 3 | <1-10> * * |
| 22 | 5 | (111) | 3 | 5 | <1-10> |
| 23 | 5 | (111) | 3 | 7.5 | <1-10> |
| 24 | 5 | (111) | 3 | 9 | <1-10> |
| 25 | 5 | (111) | 3 | 13 | <1-10> |
| 26 | 5 | (111) | 3 | 7.5 | <2-1-1> |
| | | | | | |
| 31 | 4 | (113) | 5 | 5 | <1-10> |
| 32 | 4 | (113) | 5 | 7.5 | <1-10> |
| 33 | 4 | (113) | 5 | 9 | <1-10> |

| | | | | | |
|---|---|---|---|---|---|
| * means the off-cut angle of a main surface with respect to the low-index crystal plane. ** "<I-10>" means a <1, -1, 0> direction. "-1" means a symbol "1" on which a bar is provided. | | | | | |

### <<Method of Manufacturing Single-Crystal Diamond with NV⁻ Center>>

A diamond containing substitutional nitrogen was irradiated with an electron beam at an energy of 3 MeV and at an electron dose of 1 × 10¹⁸ cm⁻². This was followed by annealing in a vacuum of 10⁻¹ Pa or less at 950°C for 1 hour. Finally, a single-crystal diamond with a NV⁻ center was manufactured by hot mixed acid treatment. It was confirmed that a NV⁻ center with an emission peak of a zero-phonon line at 638 nm was formed.

### «Characterization of Single-Crystal Diamond»

Observation of a crystal, measurement of an off-cut angle, measurement of the single proportion of a growth sector, and measurement of the density of dislocation defects were performed in the single-crystal diamond thus manufactured. Tables 2-1 and 2-2 show the results.

### <Observation of Crystal>

A synthesized crystal was observed with a typical optical microscope capable of length measurement. An optical microscope capable of photographing a photoluminescence image and a scanning electron microscope capable of photographing a cathodoluminescence image were used in combination. A function of the optical microscope was utilized to observe the surface profile and measure the size.

### <Measurement of Off-Cut Angle>

For the off-cut angle between the main surface of the seed substrate and a crystal, a diffraction peak of a low-index crystal plane with respect to the main surface was measured with an X-ray diffractometer as a deviation from the perpendicular line of the main surface. The off-cut angle of a grown crystal was also measured by the X-ray diffractometer with respect to the main surface of an off-cut angle growth region. When a plate material is cut out from a grown crystal, with respect to the cut out substrate main surface (relatively close to a main growth surface), the off-cut angle of a low-index crystal plane is measured with an X-ray diffractometer in one piece, and the off-cut angle of a growth striation of an off-cut angle growth region with respect to the substrate main surface is measured in another piece, and these are converted into the off-cut angle between the growth striation and the low-index crystal plane. It has been confirmed that the growth striation (growth striation plane) is parallel to the main growth surface. The growth striation can be identified by observing a striation pattern formed by shading of a fluorescence image (luminescence image) of a cross section. More precisely, a cross section in which a growth striation is almost parallel to the substrate main surface and a cross section perpendicular thereto are prepared, and the inclination with respect to the substrate main surface is observed from a growth striation of the latter cross section to calculate the off-cut angle. Furthermore, a three-dimensional fluorescence microscope can be used to easily measure the off-cut angle between the cut out main surface and a growth striation, and, together with the measurement results by X-ray diffraction, the off-cut angle can be converted into the off-cut angle between the main growth surface and the low-index crystal plane.

### <Measurement of Single Proportion of Growth Sector>

A growth sector was observed in a photoluminescence image or a cathodoluminescence image. Due to their different impurity concentrations, regions grown in different plane orientations can be observed in the pattern as different luminescence intensities derived from the impurities. Using a photoluminescence apparatus without a length measurement function, such as Diamond View, a photograph of a single-crystal diamond is taken and compared with an optical microscope image in which a length was measured, thereby determining the size, area, and the like of the region. A fluorescence microscope (photoluminescence apparatus) with a length measurement function can be directly used for the measurement. Typically, the surface is focused to measure the surface distribution. The inside was observed by preparing a cross-sectional sample. A confocal microscope could also be used to nondestructively measure the distribution of sectors inside a crystal. The same results were obtained by these methods.

### <Measurement of Density of Linear Defects>

Linear defects are linear defects including edge dislocation, screw dislocation, and the like. A linear defect reaching a surface of a single-crystal diamond mainly appears as a pit by subsequent etching treatment. Thus, in the present example, the density of linear defects is measured as an etch-pit density in the following treatment.

A single-crystal diamond was immersed in a potassium nitrate (KNO₃) solution as an etchant and was heated in a platinum crucible at 600 to 700°C for 0.5 to 2 hours. After slow cooling, the single-crystal diamond was taken out, and the main growth surface was observed with an optical microscope. An inverted pyramidal etch pit was observed, and the size of the etch pit was adjusted by the crucible temperature and the treatment time depending on the etch-pit density. For this adjustment, first, the conditions were determined after the density was roughly determined by treatment under conditions where a small etch pit could be formed. The size was determined for each etch-pit density such that etch pits did not overlap. The number of etch pits did not change while the etch pits were enlarged, and the size of etch pits was adjusted to the size of the field of view to be evaluated (the density of etch pits). As an example of the adjustment, at an etch-pit density as high as 5000 /cm² or more, the size of etch pits ranged from approximately 5 to 20 µm square such that etch pits did not overlap. Next, three portions with a high density were selected in a growth surface, and the number of etch pits was counted up to an area containing approximately 100 etch pits in a rectangular measurement region of 1 mm or less. The average etch-pit density was calculated from the area and the number of etch pits determined in the three portions. When the etch-pit density was less than 5000 /cm², the etch pits were gradually increased in size to be observed with a microscope even at low magnification. In a sample in which a portion with a high density could not be determined, etch pits were counted over the entire sample growth surface and were calculated from the total surface area. On the basis of the above procedure, the number of etch pits per cm² was calculated. The term "etch pit", as used herein, refers to a clear inverted pyramidal pit. Etch pits of approximately the same size are distributed and can be identified as etch pits. In a sample of 5000 /cm² or more, etch pits with a size of up to 1/4 of the size of the majority of etch pits (when a frequency distribution was created, the etch pits with the highest frequency among the etch pits with a size of at least half the maximum etch-pit size) were counted. In a sample of less than 5000 /cm², etch pits with a size of up to 1/8 of the size of the majority of etch pits (when a frequency distribution was created, the etch pits with the highest frequency among the etch pits with a size of at least half the maximum etch-pit size) were counted.

**[Table 2-1]**

| Sample | Single-crystal | | | | | | | | | | |
|---|---|---|---|---|---|---|---|---|---|---|---|
| | Size (mm) | Low-index crystal plane (hkl) plane | h+k+l | Off-cut angle* (° ) | Off direction | Volume percentage of region with off cut angle (%) | Main growth sector | Single proportion of growth sector** (%) | Density of linear defects (/cm²) | Half-width of ODMR (MHz) | Fluorescence intensity (comparison) |
| 1 | 10 | (001) | 1 | 0.15 | <100> | 1 | Second growth sector | 96 | 2500 | 18 | 5 |
| 2 | 9 | (001) | 1 | 0.82 | <100> | 2.2 | Second growth sector | 92 | 300 | 11 | 7 |
| 3 | 7 | (001) | 1 | 2.4 | <100> | 3.8 | Second growth sector | 88 | 5 | 4 | 14 |
| 4 | 6 | (001) | 1 | 7.5 | <100> | 12 | Second growth sector | 80 | 8 | 5 | 12 |
| 5 | 6.5 | (001) | 1 | 9 | <100> | 11 | Second growth sector | 75 | 110 | 11 | 9 |
| 6 | 6.5 | (001) | 1 | 14.5 | <100> | 26 | Second growth sector | 52 | 150 | 12 | 9 |
| 7 | 6.5 | (001) | 1 | 19.5 | <100> | 54 | Second growth sector | 67 | 800 | 13 | 8 |
| 8 | 9 | (001) | 1 | 7.5 | <100> | 48 | Second growth sector | 65 | 15 | 6 | 11 |
| 9 | 7.5 | (001) | 1 | 7.5 | <100> | 9 | Second growth sector | 70 | 20 | 7 | 10 |
| 10 | 6 | (001) | 1 | 7.5 | <100> | 63 | First growth sector | 52 | 60 | 8 | 13 |
| 11 | 5.5 | (001) | 1 | 9 | <100> | 85 | First growth sector | 75 | 170 | 12 | 12 |
| 12 | 5.8 | (001) | 1 | 7.5 | <100> | 73 | First growth sector | 58 | 70 | 9 | 15 |
| 13 | 5.2 | (001) | 1 | 2.8 | <100> | 79 | First growth sector | 68 | 90 | 9 | 18 |
| 14 | 7 | (001) | 1 | 3 | <110> | 5 | Second growth sector | 90 | 6 | 9 | 8 |
| 101 | 0.5 | (001) | 1 | 0 | - | 0 | Second growth sector | 30 | 30000 | 21 | 1 |

| | | | | | | | | | | | |
|---|---|---|---|---|---|---|---|---|---|---|---|
| * means the off-cut angle of a main growth surface with respect to the low-index crystal plane. ** means the area percentage based on the area of a main growth surface in an off growth region. | | | | | | | | | | | |

**[Table 2-2]**

| Sample | Single-crystal diamond | | | | | | | | | | |
|---|---|---|---|---|---|---|---|---|---|---|---|
| | Size (mm) | Low-index crystal plane (hkl) plane | h+k+l | Off-cut angle* (° ) | Off direction | Volume percentage of region with off-cut angle (%) | Main growth sector | Single proportion of growth sector* * (%) | Density of linear defects (/cm²) | Half-width of ODMR (MHz) | Fluorescence intensity (comparison) |
| 21 | 5.8 | (111) | 3 | 3 | <100> | 35 | Second growth sector | 80 | 20 | 6 | 21 |
| 22 | 5.8 | (111) | 3 | 5 | <100> | 52 | Second growth sector | 63 | 15 | 6 | 23 |
| 23 | 6 | (111) | 3 | 7.5 | <100> | 66 | First growth sector | 52 | 10 | 5 | 25 |
| 24 | 6 | (111) | 3 | 9 | <100> | 70 | First growth sector | 58 | 20 | 6 | 26 |
| 25 | 6 | (111) | 3 | 13 | <100> | 82 | First growth sector | 70 | 20 | 5 | 28 |
| 26 | 6 | (111) | 3 | 7.5 | <100> | 66 | First growth sector | 75 | 10 | 5 | 28 |
| | | | | | | | | | | | |
| 31 | 5 | (113) | 5 | 5 | <1-10>*** | 34 | Second growth sector | 90 | 150 | 15 | 6 |
| 32 | 5 | (113) | 5 | 7.5 | <1-10> | 55 | First growth sector | 40 | 110 | 12 | 7 |
| 33 | 5 | (113) | 5 | 9 | <1-10> | 64 | First growth sector | 50 | 130 | 14 | 6 |

| | | | | | | | | | | | |
|---|---|---|---|---|---|---|---|---|---|---|---|
| * means the off cut angle of a main growth surface with respect to the low-index crystal plane. ** means the area percentage based on the area of a main growth surface in an off-growth region. * * * "<1-10>" means a <1, -1, 0> direction. "-1" means a symbol "1" on which a bar is provided. | | | | | | | | | | | |

### <<Performance Evaluation of Single-Crystal Diamond>>

A single-crystal diamond thus manufactured was evaluated for magnetic sensitivity and fluorescence intensity by the following methods. Tables 2-1 and 2-2 show the results. An optically detected magnetic resonance spectrum was evaluated. A single-crystal diamond sample to which nitrogen had been added was irradiated with an electron beam at an energy of 3 MeV and at a dose of 10¹⁸ cm⁻², and was annealed in a vacuum at 900°C for 1 hour. In this way, a light-emitting center of nitrogen and vacancy can be formed. The optically detected magnetic resonance of the light-emitting center can be examined to confirm the appropriateness of the crystal or the appropriateness of using the crystal as a sensor. The light-emitting center is irradiated with an approximately 530-nm laser for excitation focused to a diameter of 200 µm, and the fluorescence intensity in the range of 630 nm to 700 nm is measured during microwave irradiation at a frequency of approximately 2.87 GHz. The fluorescence intensity can be measured to evaluate an optically detected magnetic resonance spectrum. In this spectrum, the horizontal axis represents the microwave frequency, and the vertical axis represents the fluorescence intensity. A sample is irradiated with a laser beam for excitation under a microscope, and returning fluorescence can be measured through a filter that cuts off the excitation light and transmits light with a wavelength of more than 630 nm. Although a specific fluorescence intensity is observed when there is no resonance with the light-emitting center, the fluorescence intensity decreases and a resonance spectrum is obtained at a specific microwave frequency. The "magnetic sensitivity" was correlated with the frequency width of a trailing edge of this resonance (the half-width of ODMR) and was evaluated by the frequency width. For the "fluorescence intensity", the fluorescence intensity without resonance was compared with the fluorescence intensity of a reference sample. This intensity was compared under the same measurement conditions and after the number of light-emitting centers in the sample was converted into the same value. The "fluorescence contrast ratio" was defined as the ratio of the fluorescence intensity with resonance to the fluorescence intensity without resonance.

In the present example, Samples 1 to 14, Samples 21 to 26, and Samples 31 to 33 correspond to examples. Sample 101 corresponds to a comparative example. As is clear from Tables 2-1 and 2-2, the single-crystal diamond according to the present embodiment has high magnetic sensitivity and fluorescence intensity.

It is to be understood that the embodiments and examples disclosed above are illustrated by way of example and not by way of limitation in all respects. The scope of the present invention is defined by the appended claims rather than by the embodiments and examples described above. All modifications that fall within the scope of the claims and the equivalents thereof are therefore intended to be embraced by the claims.

### Reference Signs List

- 1: single-crystal diamond
- 2: insulator
- 3: carbon source
- 4: solvent metal
- 5: seed substrate
- 6: pressure medium
- 7: graphite heater
- 20: main growth surface (growth surface with growth striation off)
- 21: growth striation
- 22: low-index crystal plane
- 23: off-cut angle
- 24: linear defect
- 25: growth surface with growth striation on just-surface
- 31: first growth sector
- 32: second growth sector
- 33: third growth sector
- 34: fourth growth sector
- 50: diamond composite

## Claims

1. A single-crystal diamond comprising: a growth striation parallel to a main growth surface; and a low-index crystal plane,
wherein the growth striation in at least part of the single-crystal diamond has an off-cut angle with respect to the low-index crystal plane.

2. A single-crystal diamond comprising: a linear defect extending toward a main growth surface; and a crystal axis of a low-index crystal plane,
wherein the crystal axis in at least part of the single-crystal diamond has an off-cut angle with respect to an average direction of the linear defect extending toward the main growth surface.

3. The single-crystal diamond according to claim 1 or 2, wherein the off-cut angle ranges from 0.1 degrees to 20 degrees.

4. The single-crystal diamond according to claim 3, wherein the off-cut angle ranges from 0.8 degrees to 15 degrees.

5. The single-crystal diamond according to any one of claims 1 to 4, wherein the low-index crystal plane is an (hkl) plane, and a sum of h, k, and 1 is 5 or less.

6. The single-crystal diamond according to claim 5, wherein the (hkl) plane is a (100) plane or a (111) plane.

7. The single-crystal diamond according to claim 6, wherein the (hkl) plane is a (111) plane, and a side is <110>.

8. The single-crystal diamond according to any one of claims 1 to 7, wherein a region with the off-cut angle in the single-crystal diamond has a volume percentage of 0.8% by volume or more.

9. The single-crystal diamond according to any one of claims 1 to 8, wherein a sum of a growth surface forming an off-cut angle between the growth striation and the low-index crystal plane and a just-growth surface on which the off-cut angle is eliminated is a maximum compared with an area of a plane with another plane orientation.

10. The single-crystal diamond according to any one of claims 1 to 8, wherein a sum of a growth surface forming an off-cut angle between a linear defect and a crystal axis of the low-index crystal plane and a just-growth surface on which the off-cut angle is eliminated is a maximum compared with an area of a plane with another plane orientation.

11. The single-crystal diamond according to claim 9 or 10, wherein the growth surface is 1.5 times or more larger than other surfaces of the single-crystal diamond.

12. The single-crystal diamond according to any one of claims 1 to 11, wherein the single-crystal diamond has a size of 5 mm or more.

13. The single-crystal diamond according to any one of claims 1 to 12, comprising at least one growth sector,
wherein the growth sector has a single proportion of 50% or more based on an area of the main growth surface.

14. The single-crystal diamond according to any one of claims 1 to 13, comprising two or more growth sectors,
wherein at least one sector boundary is a boundary between a low-index crystal plane growth sector and an off-cut angle plane growth sector.

15. A diamond composite comprising:
the single-crystal diamond according to any one of claims 1 to 14; and
a seed substrate,
wherein the seed substrate has a main surface and a low-index crystal plane, and
the main surface has an off-cut angle with respect to the low-index crystal plane of the seed substrate.

16. The diamond composite according to claim 15, wherein the seed substrate has a size of 2 mm or more.
